# EUROPEAN PATENT SPECIFICATION

(11) **EP 3 358 629 B1**
(45) Date of publication and mention of the grant of the patent: **26.08.2020**
(21) Application number: 16851388.5
(22) Date of filing: 26.09.2016
(51) Int. Cl.: H01L 31/048, B32B 27/32, B32B 7/12, B32B 15/085, B32B 15/092, B32B 15/082, B32B 15/18, B32B 15/20, B32B 27/08, B32B 27/20, B32B 27/26, B32B 27/30, B32B 27/38, B32B 27/36, C09J 123/08, C08L 23/08, C09J 7/24

(54) **MULTILAYER SHEET FOR SOLAR CELL SEALING MATERIAL, METHOD FOR MANUFACTURING MULTILAYER SHEET FOR SOLAR CELL SEALING MATERIAL, AND SOLAR CELL MODULE**
MEHRSCHICHTIGE FOLIE FÜR SOLARZELLENDICHTUNGSMATERIAL, VERFAHREN ZUR HERSTELLUNG EINER MEHRSCHICHTIGEN FOLIE FÜR EIN SOLARZELLENDICHTUNGSMATERIAL UND SOLARZELLENMODUL
FEUILLE MULTICOUCHE POUR PRODUIT D'ÉTANCHÉITÉ DE CELLULE SOLAIRE, PROCÉDÉ DE FABRICATION DE FEUILLE MULTICOUCHE POUR PRODUIT D'ÉTANCHÉITÉ DE CELLULE SOLAIRE, ET MODULE DE CELLULE SOLAIRE

(30) Priority: 29.09.2015 JP 2015191210
(43) Date of publication of application: 08.08.2018
(73) Proprietor: DOW-MITSUI POLYCHEMICALS CO., LTD., Tokyo 1057122 (JP)
(72) Inventor: ENDO, Yui, Tokyo 105-7122 (JP); SATO, Norihiko, Ichihara-shi Chiba 299-0108 (JP); ICHINOSEKI, Chikara, Ichihara-shi Chiba 299-0108 (JP); ISOKAWA, Motoaki, Ichihara-shi Chiba 299-0108 (JP)
(74) Representative: Gulde & Partner
(86) International application number: PCT/JP2016/078159
(87) International publication number: WO 2017/057217

(56) References cited:
- JP-A- 2000 186 114
- JP-A- 2012 015 205
- JP-A- 2014 040 542
- JP-A- 2015 005 646
- US-A1- 2008 264 481
- US-A1- 2012 024 348

## Description

### TECHNICAL FIELD

The present invention relates to a solar cell encapsulant multilayer sheet, a method of manufacturing a solar cell encapsulant multilayer sheet, and a solar cell module.

### BACKGROUND ART

Under the circumstances of a recent increase in environmental problems, attention has been paid to solar photovoltaic power generation as clean energy.

Solar photovoltaic power generation directly converts sunlight energy into electrical energy using a semiconductor (solar cell element) such as a silicon cell. A solar cell element used herein is thin and is likely to break. Therefore, in a case where a solar cell element comes into direct contact with external air, a function of the solar cell element may deteriorate. Therefore, a solar cell element is interposed between encapsulants to protect the solar cell element and to prevent incorporation of foreign matter or infiltration of water or the like. In addition, in order to cause sunlight to be efficiently incident on a solar cell element, transparency is required for an encapsulant.

As a solar cell encapsulant, a material including an ethylene/vinyl acetate copolymer as a major component is widely used from the viewpoints of, for example, superior transparency, adhesion performance, and costs (for example, refer to Patent Documents 1 to 3).

### RELATED DOCUMENT

### PATENT DOCUMENT

[Patent Document 1] Japanese Unexamined Patent Application Publication No. 2002-190610
[Patent Document 2] Japanese Unexamined Patent Application Publication No. 2010-53298
[Patent Document 3] Japanese Unexamined Patent Application Publication No. 2011-140588
   US2012/024348A1 relates to a solar cell encapsulating sheet with a two layer structure.

### SUMMARY OF THE INVENTION

The technical level required for achieving various properties of a solar cell encapsulant has increasingly become higher. The present inventors found the following problems regarding a solar cell encapsulant including an ethylene/vinyl acetate copolymer as a major component.

First, the solar cell encapsulant including an ethylene/vinyl acetate copolymer as a major component has poor moisture resistance. Therefore, depending on the kind of a transparent substrate, a back sheet, or the like disposed on an incidence side of sunlight, adhesion conditions, an usage environment of a solar cell, and the like, performance of a solar cell may deteriorate due to infiltration of water into a solar cell module.

In addition, the solar cell encapsulant including an ethylene/vinyl acetate copolymer has a lower volume resistivity than a general polyolefin material and thus may be insufficient in insulating performance as a material for protecting a high-power and high-performance solar cell.

This way, the present inventors found that solar cell encapsulants of the related art described in Patent Documents 1 to 3 have insufficient moisture resistance and insulating performance.

Further, according to the investigation by the present inventors, the following was found. In a solar cell encapsulant including an ethylene/vinyl acetate copolymer, in a case where the content of vinyl acetate in the ethylene/vinyl acetate copolymer is reduced, the water-vapor permeability decreases such that moisture resistance is improved, and the volume resistivity increases such that insulating performance is improved. However, transparency or adhesion performance deteriorates.

That is, a trade-off relationship is established between transparency and adhesion performance, and moisture resistance and insulating performance, and it is obvious that the trade-off relationship cannot be improved by improving the composition of a polymer. That is, the present inventors found that, a solar cell encapsulant of the related art has room for improvement from the viewpoint of improving transparency, adhesion performance, moisture resistance, and insulating performance with a good balance.

The present invention has been made in consideration of the above-described circumstances, and an object thereof is to provide a solar cell encapsulant multilayer sheet having a good performance balance between transparency, adhesion performance, moisture resistance, and insulating performance.

### Solution to Problem

The present inventors performed a thorough investigation in order to achieve the object. As a result, the present inventors found that, by laminating a resin layer that includes an ethylene/unsaturated carboxylic acid copolymer or an ionomer of the ethylene/unsaturated carboxylic acid as a major component and an adhesive layer that includes a specific ethylene based copolymer, the trade-off relationship can be improved, and transparency, adhesion performance, moisture resistance, and insulating performance can be improved with a good balance, thereby completing the present invention.

That is, the present invention provides a solar cell encapsulant multilayer sheet, a method of manufacturing a solar cell encapsulant multilayer sheet, and a solar cell module described below.
[1] A solar cell encapsulant multilayer sheet including:
   a resin layer (A) that includes an ethylene/unsaturated carboxylic acid copolymer or an ionomer of the ethylene/unsaturated carboxylic acid copolymer as a major component; and
   an adhesive layer (B) that is provided on both surfaces of the resin layer (A),
   in which the adhesive layer (B) includes an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower.
[2] The solar cell encapsulant multilayer sheet according to [1],
   in which a total thickness is 50 µm or more and 2000 µm or less.
[3] The solar cell encapsulant multilayer sheet according to any one of [1] to [2],
   in which the epoxy group-containing ethylene based copolymer (B1) includes at least one selected from the group consisting of an ethylene/glycidyl (meth)acrylate copolymer, an ethylene/glycidyl (meth)acrylate/vinyl acetate copolymer, and an ethylene/glycidyl (meth)acrylate/(meth)acrylic acid ester copolymer.
[4] The solar cell encapsulant multilayer sheet according to any one of [1] to [3],
   in which the ethylene/polar monomer copolymer includes at least one selected from the group consisting of an ethylene/vinyl ester copolymer, an ethylene/unsaturated carboxylic acid ester copolymer, and an ethylene/unsaturated carboxylic acid copolymer.
[5] The solar cell encapsulant multilayer sheet according to any one of [1] to [4],
   in which at least a part of the epoxy group-containing ethylene based copolymer (B1) and the ethylene based copolymer (B2) in the adhesive layer (B) is graft-modified by a silane coupling agent.
[6] The solar cell encapsulant multilayer sheet according to any one of [1] to [5],
   in which a content of the ethylene based copolymer (B2) in the adhesive layer (B) is 50 mass% or higher and 99 mass% or lower with respect to 100 mass% of a total amount of the epoxy group-containing ethylene based copolymer (B1) and the ethylene based copolymer (B2).
[7] The solar cell encapsulant multilayer sheet according to any one of [1] to [6],
   in which the resin layer (A) includes an ionomer of the ethylene/unsaturated carboxylic acid copolymer as a major component.
[8] The solar cell encapsulant multilayer sheet according to any one of [1] to [7],
   in which the solar cell encapsulant multilayer sheet is used for adhesion with an electrically insulating resin film layer having at least one surface that is not corona-treated.
[9] A method of manufacturing the solar cell encapsulant multilayer sheet according to any one of [1] to [8], the method including:
   a step of extruding a resin composition (A) and a resin composition (B) by multilayer extrusion, the resin composition (A) including an ethylene/unsaturated carboxylic acid copolymer or an ionomer of the ethylene/unsaturated carboxylic acid copolymer as a major component, and the resin composition (B) including an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower.
[10] A solar cell module comprising:
   a substrate on which sunlight is incident;
   a solar cell element;
   a back sheet;
   an encapsulating resin layer that is formed of the solar cell encapsulant multilayer sheet according to any one of [1] to [8] and encapsulates the solar cell element between the substrate and the back sheet.

### Advantageous Effects of Invention

According to the present invention, a solar cell encapsulant multilayer sheet having a good performance balance between transparency, adhesion performance, moisture resistance, and insulating performance can be provided.

In addition, the multilayer sheet can be used as an intermediate film for laminated glass. Therefore, an intermediate film for laminated glass and a laminated glass having a good performance balance between transparency, adhesion performance, and moisture resistance can be provided.

### BRIEF DESCRIPTION OF THE DRAWINGS

The above-described object, other objects, characteristics, and advantageous effects will be further described in detail using the following preferred embodiments and the accompanying drawings.

Fig. 1 is a cross-sectional view schematically showing an example of a structure of a solar cell encapsulant multilayer sheet according to an embodiment of the present invention.
Fig. 2 is a cross-sectional view schematically showing an example of a structure of a solar cell module according to an embodiment of the present invention.

### DESCRIPTION OF EMBODIMENTS

Hereinafter, embodiments of the present invention will be described using the drawings. "X to Y" in a numerical range represents "X or more and Y or less" unless specified otherwise. In addition, "(meth)acryl represents either or both of acryl and methacryl.

### 1. Regarding Solar Cell Encapsulant Multilayer Sheet

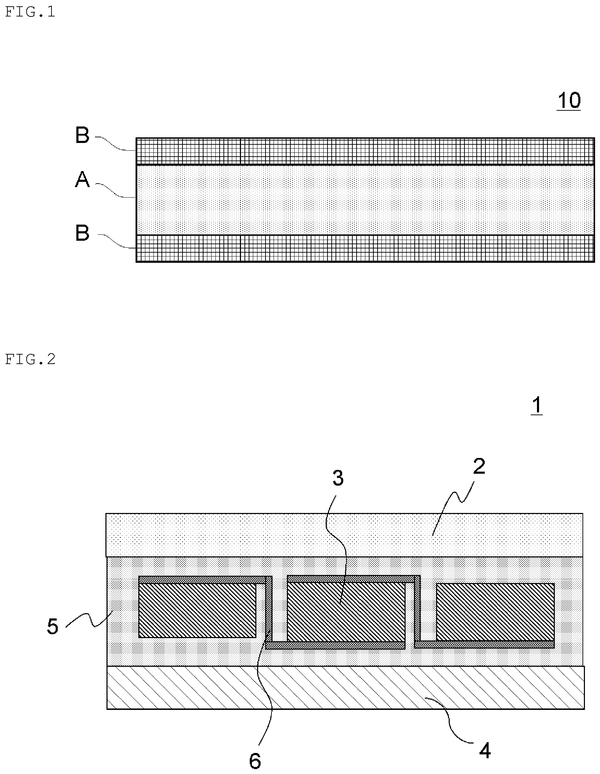

Fig. 1 is a cross-sectional view schematically showing an example of a structure of a solar cell encapsulant multilayer sheet 10 according to an embodiment of the present invention.

The solar cell encapsulant multilayer sheet 10 (hereinafter, also referred to as "multilayer sheet") according to the embodiment is used for encapsulating a solar cell element, and includes: a resin layer (A) that includes an ethylene/unsaturated carboxylic acid copolymer or an ionomer of the ethylene/unsaturated carboxylic acid copolymer as a major component; and an adhesive layer (B) that is provided on both surfaces of the resin layer (A). The embodiment of the present invention also includes a configuration in which, for example, a layer other than the resin layer (A) and the adhesive layer (B) is interposed between the resin layer (A) and the adhesive layer (B). However, it is preferable that the resin layer (A) and the adhesive layer (B) are in direct contact with each other.

The adhesive layer (B) includes an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower.

In the solar cell encapsulant multilayer sheet 10 according to the embodiment including the resin layer (A) and the adhesive layer (B), transparency, adhesion performance, moisture resistance, and insulating performance can be improved with a good balance as compared to a solar cell encapsulant sheet including an ethylene/vinyl acetate copolymer which is used in the related art. In particular, moisture resistance and adhesion performance are superior. Therefore, wet adhesion performance and long-term adhesion stability are superior. In addition, in the solar cell encapsulant multilayer sheet 10 according to the embodiment, a surface of an electrically insulating resin film layer such as a polyester film that is not corona-treated also has superior adhesion performance.

In the resin layer (A), it is preferable that the layer including an ethylene/unsaturated carboxylic acid copolymer or an ionomer thereof as a major component is formed of a single layer. However, the layer including an ethylene/unsaturated carboxylic acid copolymer or an ionomer thereof as a major component may be formed of a plurality of layers which are different from each other, for example, in the composition of the ethylene/unsaturated carboxylic acid copolymer or in proportions of copolymerizable monomers in the ethylene/unsaturated carboxylic acid copolymer.

"The major component" represents the content of the ethylene/unsaturated carboxylic acid copolymer or the ionomer thereof in the resin layer (A) is 60 mass% or higher.

The adhesive layer (B) is provided on both surfaces of the resin layer (A) from the viewpoint of improving adhesion performance of the multilayer sheet with a solar cell element, a transparent substrate, and a back sheet with a good balance.

In addition, as in the case of the resin layer (A), it is also preferable that the adhesive layer (B) is formed of a single layer. However, the adhesive layer (B) may be formed of a plurality of layers which are different from each other in the composition or mixing amount of the copolymer.

The solar cell encapsulant multilayer sheet 10 according to the embodiment are formed of a plurality of layers including the resin layer (A) and the adhesive layer (B), is more preferably a two-layer sheet including the resin layer (A) and the adhesive layer (B), and is still more preferably a three-layer sheet including an intermediate layer that is formed of the resin layer (A) and two outer layers that are formed of the adhesive layer (B) and are provided on both surfaces of the intermediate layer, respectively.

In the embodiment, the total thickness of the solar cell encapsulant multilayer sheet 10 is preferably 50 µm or more and 2000 µm or less, more preferably 50 µm or more and 1000 µm or less, and still more preferably 50 µm or more and 800 µm or less. In a case where the total thickness of the solar cell encapsulant multilayer sheet 10 is the lower limit value or more, breaking of a solar cell element caused by impact or the like can be further suppressed. In addition, in a case where the total thickness of the solar cell encapsulant multilayer sheet 10 is in the upper limit value or lower, the transparency of the sheet can be further improved, the amount of sunlight can be secured, and a higher power can be maintained.

In addition, the multilayer sheet according to the embodiment has a good performance balance between transparency, adhesion performance, moisture resistance, and insulating performance. Therefore, the total thickness of the multilayer sheet can be reduced to be 800 µm or less.

In a case where the multilayer sheet according to the embodiment is a two-layer sheet including the resin layer (A) and the adhesive layer (B), a ratio (a/b) of the thickness (a) of the resin layer (A) to the thickness (b) of the adhesive layer (B) is 1/1 to 10/1 and preferably 2/1 to 6/1. In a case where a/b is in the above-described range, a performance balance between transparency, adhesion performance, moisture resistance, insulating performance, flexibility, heat resistance, and workability can be further improved.

In addition, in a case where the multilayer sheet according to the embodiment is a three-layer sheet including an intermediate layer that is formed of the resin layer (A) and two outer layers that are formed of the adhesive layer (B) and are provided on both surfaces of the intermediate layer, respectively, a ratio (a/b) of the thickness (a) of one layer of the resin layer (A) to the thickness (b) of one layer of the adhesive layer (B) is 1/1 to 10/1 and preferably 2/1 to 6/1. In a case where a/b is in the above-described range, a performance balance between transparency, adhesion performance, moisture resistance, insulating performance, flexibility, heat resistance, and workability can be further improved. As long as the thickness ratio is in the above-described range, the two outer layers may have different thicknesses.

In the solar cell encapsulant multilayer sheet 10 according to the embodiment, a bending elastic modulus measured according to JIS K 7171 is preferably 50 MPa or higher and 500 MPa or lower and more preferably 100 MPa or higher and 450 MPa or lower. In a case where the bending elastic modulus is in the above-described range, a balance between the performance of the solar cell encapsulant multilayer sheet 10 such as breaking strength, impact resistance, or protrusion resistance and the productivity of a solar cell module can be further improved. In order to achieve the bending elastic modulus, the composition of the resin layer (A), the composition of the adhesive layer (B), the thickness ratio of the resin layer (A) to the adhesive layer (B), and the like may be appropriately adjusted.

In the solar cell encapsulant multilayer sheet 10 according to the embodiment, a water-vapor permeability measured according to JIS Z 0208 under conditions of a temperature of 40°C and a humidity of 90% RH is preferably 15 g/ (m²·24h) or lower, more preferably 10 g/ (m²·24h) or lower, and still more preferably 5 g/ (m²·24h) or lower.

In the solar cell encapsulant multilayer sheet 10 in which the water-vapor permeability is the upper limit value or lower, it is difficult to hold water, corrosion of a solar cell element or an electrode can be suppressed. As a result, long-term stability of a solar cell module can be further improved.

In the solar cell encapsulant multilayer sheet 10 according to the embodiment, a haze value measured according to JIS K 7136 is preferably 40 % or lower, more preferably 35% or lower, and still more preferably 30% or lower.

The amount of power generated from the obtained solar cell module can be further improved.

### <Resin Layer (A)>

The resin layer (A) includes an ethylene/unsaturated carboxylic acid copolymer or an ionomer thereof as a major component.

In the ethylene/unsaturated carboxylic acid copolymer or the ionomer thereof, the content of a constitutional unit derived from ethylene is preferably 65 mass% or higher and 95 mass% or lower and more preferably 75 mass% or higher and 92 mass% or lower, and the content of a constitutional unit derived from an unsaturated carboxylic acid is preferably 5 mass% or higher and 25 mass% or lower and more preferably 8 mass% or higher and 25 mass% or lower.

In a case where the content of the constitutional unit derived from ethylene is the lower limit value or higher, the heat resistance, mechanical strength, and the like of the multilayer sheet can be further improved. In addition, in a case where the content of the constitutional unit derived from ethylene is the upper limit value or lower, the transparency, flexibility, adhesion performance, and the like of the multilayer sheet can be further improved.

In addition, in a case where the content of the constitutional unit derived from an unsaturated carboxylic acid is the lower limit value or higher, the transparency, flexibility, adhesion performance, and the like of the multilayer sheet can be further improved. In addition, in a case where the content of the constitutional unit derived from an unsaturated carboxylic acid is the upper limit value or lower, the workability of the multilayer sheet can be further improved.

Examples of the unsaturated carboxylic acid in the ethylene/unsaturated carboxylic acid copolymer include acrylic acid, methacrylic acid, maleic acid, fumaric acid, itaconic acid, maleic anhydride, itaconic anhydride, monomethyl maleate, and monoethyl maleate. Among these, at least one selected from the group consisting of acrylic acid and methacrylic acid is preferable from the viewpoints of productivity, hygiene, and the like of the ethylene/unsaturated carboxylic acid copolymer.

As the unsaturated carboxylic acid, one kind may be used alone, or a combination of two or more kinds may be used.

In the ethylene/unsaturated carboxylic acid copolymer, the content of constitutional units derived from other copolymerizable monomers is preferably 0 mass% or higher and 30 mass% or lower, and more preferably 0 mass% or higher and 25 mass% or lower with respect to 100 mass% of the total amount of ethylene and the unsaturated carboxylic acid copolymer. Examples of the other copolymerizable monomers include unsaturated esters including: a vinyl ester such as vinyl acetate or vinyl propionate; and a (meth)acrylic acid ester such as methyl (meth)acrylate, ethyl (meth)acrylate, isobutyl (meth)acrylate, n-butyl (meth)acrylate, or 2-ethylhexyl (meth)acrylate. It is preferable that the content of the constitutional units derived from the other copolymerizable monomers is in the above-described range from the viewpoint of improving the flexibility of the multilayer sheet.

In the embodiment, the ionomer of the ethylene/unsaturated carboxylic acid copolymer may be used instead of the ethylene/unsaturated carboxylic acid copolymer. By the resin layer (A) including the ionomer of the ethylene/unsaturated carboxylic acid copolymer as a major component, the water-vapor permeability of the solar cell encapsulant multilayer sheet 10 decreases and the moisture resistance can be further improved.

Examples of an ion source regarding the ionomer include: an alkali metal such as lithium or sodium; and a polyvalent metal such as calcium, magnesium, zinc, or aluminum.

As the ionomer, an ionomer having a degree of neutralization of 80% or lower is typically used. In a case where the degree of neutralization is in the above-described range, a multilayer sheet having superior transparency and superior storage stability at a high temperature can be obtained. In general, from the viewpoints of the transparency, adhesion performance, and workability of the solar cell encapsulant sheet, an ionomer having a degree of neutralization of 60% or lower and preferably 40% or lower is preferable. The lower limit of the degree of neutralization is not particularly limited and, for example, is 1% or higher and preferably 5% or higher.

The ethylene/unsaturated carboxylic acid copolymer can be obtained by radical polymerization of respective polymerizable components in a high-temperature and highpressure environment. In addition, the ionomer of the ethylene/unsaturated carboxylic acid copolymer can be obtained by causing the copolymer and a metal compound to react with each other.

In the ethylene/unsaturated carboxylic acid copolymer or the ionomer thereof, a melt flow rate (JIS K 7210-1999) measured at 190°C and a load of 2160 g is preferably 0.1 g/10 min or higher 150 g/10 min or lower and more preferably 0.1 g/10 min or higher and 50 g/10 min or lower in consideration of workability and mechanical strength.

In the resin layer (A) constituting the multilayer sheet according to the embodiment, the content of the ethylene/unsaturated carboxylic acid copolymer or the ionomer thereof is typically 80 mass% or higher and preferably 90 mass% or higher. In a case where the content of the ethylene/unsaturated carboxylic acid copolymer or the ionomer thereof is in the above-described range, the transparency, insulating performance, moisture resistance, and the like of the multilayer sheet can be further improved.

The resin layer (A) may include various additives in a range where the object of the present invention can be achieved. Examples of the additives include a crosslinking agent, a crosslinking aid, a silane coupling agent, an ultraviolet absorber, a light stabilizer, and an antioxidant.

As the crosslinking agent, an organic peroxide having a 1 hour half-life decomposition temperature of typically 90°C or higher and 180°C or lower and preferably 100°C or higher and 150°C or lower is preferably used. Examples of the organic peroxide include t-butylperoxy isopropyl carbonate, t-butylperoxy acetate, t-butylperoxy benzoate, dicumyl peroxide, 2,5-dimethyl-2,5-bis(t-butylperoxy)hexane, di-t-butyl peroxide, 2,5-dimethyl-2,5-bis(t-butylperoxy)hexyne-3, 1,1-bis(t-butylperoxy)-3,3,5-trimethylcyclohexane, 1,1-bis(t-butylperoxy)cyclohexane, methyl ethyl ketone peroxide, 2,5-dimethylhexyl-2,5-bisperoxy benzoate, t-butyl hydroperoxide, p-menthane hydroperoxide, benzoyl peroxide, p-chlorobenzoyl peroxide, t-butylperoxy isobutyrate, hydroxyheptyl peroxide, and cyclohexanone peroxide.

The content of the crosslinking agent is typically 0.1 parts by mass or more and 5 parts by mass or less and preferably 0.5 parts by mass or more and 3 parts by mass or less with respect to 100 parts by mass of the ethylene/unsaturated carboxylic acid copolymer or the ionomer thereof.

Examples of the crosslinking aid include a polyunsaturated compound such as a polyallyl compound or a poly(meth)acryloxy compound. Specific examples include: a polyallyl compound such as triallyl isocyanurate, triallyl cyanurate, diallyl phthalate, diallyl fumarate, or diallyl maleate; a poly(meth)acryloxy compound such as ethylene glycol diacrylate, ethylene glycol dimethacrylate, or trimethylolpropane trimethacrylate; and divinylbenzene.

The content of the crosslinking aid is typically 5 parts by mass or less and preferably 0.1 parts by mass or more and 3 parts by mass or less with respect to 100 parts by mass of the ethylene/unsaturated carboxylic acid copolymer or the ionomer thereof.

Examples of the silane coupling agent include a silane coupling agent having a vinyl group, an amino group, or an epoxy group and a hydrolyzable group such as an alkoxy group. Specific examples include vinyltrimethoxysilane, γ-methacryloxypropyltrimethoxysilane, γ-methacryloxypropylmethyldimethoxysilane, γ-acryloxypropyltrimethoxysilane, γ-glycidoxypropyltrimethoxysilane, 3-glycidoxypropylmethyldimethoxysilane, 3-glycidoxypropylmethyldiethoxysilane, N-2-(aminoethyl)-3-aminopropyltrimethoxysilane, N-2-(aminoethyl)-3-aminopropylmethyldiethoxysilane, 3-aminopropyltrimethoxysilane, 3-aminopropyltriethoxysilane, N-phenyl-3-aminopropyltrimethoxysilane, and N-phenyl-3-aminopropyltriethoxysilane.

The content of the silane coupling agent is typically 5 parts by mass or less and preferably 0.02 parts by mass or more and 3 parts by mass or less with respect to 100 parts by mass of the ethylene/unsaturated carboxylic acid copolymer or the ionomer thereof. In a case where the content of the silane coupling agent is in the above-described range, the adhesion performance of the multilayer sheet with a protective material, a solar cell element, or the like can be further improved.

In addition, in order to prevent the multilayer sheet from deteriorating due to ultraviolet light, it is preferable that resin layer (A) includes an ultraviolet absorber, a light stabilizer, and an antioxidant.

Examples of the ultraviolet absorber which can be used include: a benzophenone ultraviolet absorber such as 2-hydroxy-4-methoxybenzophenone, 2,2'-dihydroxy-4-methoxybenzophenone, 2-hydroxy-4-methoxy-2-carboxybenzophenone, or 2-hydroxy-4-n-octoxybenzophenone; a benzotriazole ultraviolet absorber such as 2-(2H-benzotriazol-2-yl)-4,6-di-tert-pentylphenol, 2-(2'-hydroxy-3',5'-di-t-butylphenyl)benzotriazole, 2-(2'-hydroxy-5-methylphenyl)benzotriazole, or 2-(2'-hydroxy-5-t-octylphenyl)benzotriazole; and a salicylic acid ester ultraviolet absorber such as phenyl salicylate or p-octylphenyl salicylate.

Examples of the light stabilizer which can be used include a hindered amine light stabilizer.

Examples of the antioxidant which can be used include various antioxidants such as a hindered phenol antioxidant or a phosphite antioxidant.

The content of each of the antioxidant, the light stabilizer, and the ultraviolet absorber is typically 5 parts by mass or less and preferably 0.1 parts by mass or more and 3 parts by mass or less with respect to 100 parts by mass of the ethylene/unsaturated carboxylic acid copolymer or the ionomer thereof.

In addition, the resin layer (A) may optionally include additives such as a colorant, a light diffusion agent, or a flame retardant other than the above-described additives.

Examples of the colorant include a pigment, an inorganic compound, and a dye. Examples of a white colorant include titanium oxide, zinc oxide, and calcium carbonate. In a case where the multilayer sheet including the additives is used as an encapsulant on a light receiving side of a solar cell element, transparency may deteriorate. However, the multilayer sheet including the additives can be preferably used as an encapsulant on a side of a solar cell element opposite to a light receiving side.

Examples of an inorganic spherical material as the light diffusion agent include glass beads, silica beads, silicon alkoxy beads, and hollow glass beads. Examples of an organic spherical material as the light diffusion agent include plastic beads such as acrylic beads or vinyl benzene beads.

Examples of the flame retardant include a halogen flame retardant such as a bromide, a phosphorus flame retardant, a silicone flame retardant, and a metal hydrate such as magnesium hydroxide or aluminum hydroxide.

### <Adhesive Layer (B)>

The adhesive layer (B) includes an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower.

Examples of the epoxy group-containing ethylene based copolymer (B1) include a glycidyl group-containing ethylene based copolymer.

Examples of the glycidyl group-containing ethylene based copolymer include at least one selected from the group consisting of an ethylene/glycidyl (meth)acrylate copolymer, an ethylene/glycidyl (meth)acrylate/vinyl acetate copolymer, and an ethylene/glycidyl (meth)acrylate/(meth)acrylic acid ester copolymer.

The epoxy group-containing ethylene based copolymer (B1) is obtained by copolymerization of ethylene and a monomer having a polymerizable group and an epoxy group such as glycidyl (meth)acrylate, vinyl glycidyl ether, 1,2-epoxy-4-vinylcyclohexane, or 3,4-epoxycyclohexylmethyl methacrylate. In addition, an epoxy group may be introduced into the ethylene based copolymer by graft polymerization with a monomer having an epoxy group.

A content ratio of a constitutional unit derived from a monomer such as glycidyl (meth)acrylate in the epoxy group-containing ethylene based copolymer (B1) is preferably 2 mass% or higher and 30 mass% or lower and more preferably 3 mass% or higher and 25 mass% or lower.

In a case where the content ratio of the constitutional unit derived from the monomer such as glycidyl (meth)acrylate is the lower limit value or higher, adhesion performance between the solar cell encapsulant multilayer sheet 10 and members constituting a solar cell module (for example, a solar cell element or a substrate) is further improved. In addition, in a case where the content ratio of the constitutional unit derived from the monomer such as glycidyl (meth)acrylate is the upper limit value or lower, workability as an encapsulant multilayer sheet is high, and the transparency and flexibility of the solar cell encapsulant multilayer sheet 10 is also further improved.

"Glycidyl (meth)acrylate" represents either or both of glycidyl methacrylate and glycidyl acrylate.

"The ethylene based copolymer" in the epoxy group-containing ethylene based copolymer (B1) refers to a copolymer having a constitutional unit derived from ethylene as a major component. Further, "the major component" described herein represents that the content of "the constitutional unit derived from ethylene" with respect to the total amount of all the constitutional units is the highest. For example, in the case of a copolymer formed of constitutional units which are derived from ethylene, glycidyl (meth)acrylate, and vinyl acetate, respectively, "the major component" represents that the proportion of the constitutional unit derived from ethylene is higher than that of a constitutional unit derived from glycidyl (meth)acrylate or a constitutional unit derived from vinyl acetate.

The proportion of "the constitutional unit derived from ethylene" in the epoxy group-containing ethylene based copolymer (B1) is preferably 50 mass% or higher, more preferably 65 mass% or higher, still more preferably 70 mass% or higher, and even still more preferably 80 mass% or higher. At this time, the epoxy group-containing ethylene based copolymer may further include other monomer units other than ethylene and the monomer having a polymerizable group and an epoxy group.

Examples of the other monomers include: a vinyl ester such as vinyl acetate or vinyl propionate; and an unsaturated carboxylic acid ester such as acrylic acid ester, methacrylic acid ester, ethacrylic acid ester, crotonic acid ester, fumaric acid ester, maleic acid ester, maleic anhydride ester, itaconic acid ester, or itaconic anhydride ester. As an ester group, an alkyl ester group having 1 to 12 carbon atoms can be used, and specific examples of the alkyl ester group include methyl ester, ethyl ester, n-propyl ester, isopropyl ester, n-butyl ester, isobutyl ester, secondary butyl ester, 2-ethylhexyl ester, and isooctyl ester.

Among these, at least one selected from the group vinyl acetate and (meth)acrylic acid ester is preferable.

Specifically, for example, not only a copolymer including a constitutional unit derived from ethylene and a constitutional unit derived from glycidyl (meth)acrylate but also a copolymer further including at least a constitutional unit derived from vinyl acetate or a constitutional unit derived from (meth)acrylic acid ester in addition to the above-described two constitutional units may be used.

A content ratio of the constitutional unit derived from a vinyl ester such as vinyl acetate and a constitutional unit derived from an unsaturated carboxylic acid ester such as (meth)acrylic acid ester is preferably 30 mass% or lower and more preferably 20 mass% or lower. As a result, the water-vapor permeability of the solar cell encapsulant multilayer sheet 10 decreases and the moisture resistance can be further improved.

The lower limit value of the content ratio of the constitutional unit derived from a vinyl ester such as vinyl acetate and a constitutional unit derived from an unsaturated carboxylic acid ester such as (meth)acrylic acid ester is not particularly limited and is preferably 0.1 mass% or higher, more preferably 0.5 mass% or higher, and still more preferably 1 mass% or higher. Further, the content ratio of the constitutional unit derived from a vinyl ester such as vinyl acetate or a constitutional unit derived from an unsaturated carboxylic acid ester such as (meth)acrylic acid ester is preferably 0.1 mass% or higher and 30 mass% or lower, more preferably 0.5 mass% or higher and 20 mass% or lower, and even still more preferably 1 mass% or higher and 20 mass% or lower.

As the epoxy group-containing ethylene based copolymer (B1), one kind may be used alone, or two or more kinds having different copolymerization ratios may be used in combination.

The ethylene based copolymer (B2) includes at least one selected from the group consisting of an ethylene/polar monomer copolymer and an ethylene/α-olefin copolymer having a density of 920 kg/m³ or lower.

"The ethylene based copolymer" in the ethylene based copolymer (B2) refers to a copolymer having a constitutional unit derived from ethylene as a major component. Further, "the major component" described herein represents that the proportion of "the constitutional unit derived from ethylene" is preferably 50 mass% or higher, more preferably 60 mass% or higher, still more preferably 65 mass% or higher, and even still more preferably 70 mass% or higher with respect to the total amount of all the constitutional units.

The ethylene/polar monomer copolymer may be one kind or two or more kinds selected from the group consisting of an ethylene/vinyl ester copolymer such as an ethylene/vinyl acetate copolymer, an ethylene/vinyl propionate copolymer, an ethylene/vinyl butyrate copolymer, or an ethylene/vinyl stearate copolymer; an ethylene/unsaturated carboxylic acid ester copolymer; and an ethylene/unsaturated carboxylic acid copolymer.

Here, the ethylene/unsaturated carboxylic acid ester copolymer is a polymer obtained by copolymerization of ethylene and at least one unsaturated carboxylic acid ester.

Specifically, for example, a copolymer including ethylene and an unsaturated carboxylic acid alkyl ester can be used.

Examples of the unsaturated carboxylic acid in the unsaturated carboxylic acid ester include acrylic acid, methacrylic acid, ethacrylic acid, crotonic acid, fumaric acid, maleic acid, maleic anhydride, itaconic acid, and itaconic anhydride.

As an alkyl site in the unsaturated carboxylic acid alkyl ester, for example, a group having 1 to 12 carbon atoms can be used, and specific examples thereof include an alkyl group such as methyl, ethyl, n-propyl, isopropyl, n-butyl, isobutyl, secondary butyl, 2-ethylhexyl, and isooctyl. In the embodiment, the number of carbon atoms at the alkyl site of the alkyl ester is preferably 1 to 8.

In the embodiment, as the ethylene/unsaturated carboxylic acid ester copolymer, an ethylene/(meth)acrylic acid ester copolymer is more preferable. Examples of the copolymer include an ethylene/methyl acrylate copolymer, an ethylene/ethyl acrylate copolymer, an ethylene/normal butyl acrylate copolymer, an ethylene/isobutyl acrylate copolymer, an ethylene/methyl methacrylate copolymer, an ethylene/ethyl methacrylate copolymer, an ethylene/normal butyl methacrylate copolymer, and an ethylene/isobutyl methacrylate copolymer.

Here, the ethylene/unsaturated carboxylic acid copolymer is a polymer obtained by copolymerization of ethylene and at least one unsaturated carboxylic acid. The unsaturated carboxylic acid ester may be copolymerized.

Specifically, for example, a copolymer including ethylene and an unsaturated carboxylic acid can be used.

Examples of the unsaturated carboxylic acid include acrylic acid, methacrylic acid, ethacrylic acid, crotonic acid, fumaric acid, maleic acid, maleic anhydride, itaconic acid, and itaconic anhydride.

In the embodiment, as the ethylene/unsaturated carboxylic acid copolymer, an ethylene/(meth)acrylic acid copolymer is more preferable.

The ethylene/polar monomer copolymer is more preferably at least one selected from the group consisting of an ethylene/vinyl acetate copolymer, an ethylene/methyl (meth)acrylate copolymer, an ethylene/ethyl (meth)acrylate copolymer, an ethylene/propyl (meth)acrylate copolymer, an ethylene/butyl (meth)acrylate copolymer, and an ethylene/(meth)acrylic acid copolymer. As the resin in the embodiment, one kind may be used alone, or two or more kinds may be blended and used.

The content of a polar monomer in the ethylene/polar monomer copolymer is preferably 5 mass% or higher and 40 mass% or lower, more preferably 8 mass% or higher and 35 mass% or lower, and still more preferably 8 mass% or higher and 30 mass% or lower.

In a case where the content of the polar monomer is in the above-described range, a balance between adhesion performance, transparency, mechanical properties, and film forming properties in the solar cell encapsulant multilayer sheet 10 can be further improved. The content of vinyl acetate can be measured, for example, according to JIS K 7192:1999.

A method of manufacturing the ethylene/polar monomer copolymer is not particularly limited and can be manufactured using a well-known method. For example, the ethylene/polar monomer copolymer can be manufactured using an autoclave method or a tubular method which is a highpressure well-known method of the related art. In addition, a commercially available product may be used as the ethylene/polar monomer copolymer.

In the ethylene/α-olefin copolymer having a density of 920 kg/m³ or lower in the ethylene based copolymer (B2), it is preferable that the content ratio of a constitutional unit derived from α-olefin having 3 to 20 carbon atoms is 5 mol% or higher and more preferably 10 mol% or higher with respect to 100 mol% of the content of all the constitutional units (monomer units) constituting the copolymer. In a case where the content ratio of the constitutional unit derived from the α-olefin is in the above-described range, the transparency and bleed resistance of the multilayer sheet can be further improved. In addition, in consideration of the flexibility of the multilayer sheet, it is preferable that a polymer in which the content ratio of the constitutional unit derived from the α-olefin is 15 mol% or higher is used. The upper limit is lower than 50 mol%, preferably 40 mol% or lower, and more preferably 30 mol% or lower.

Specific examples of α-olefin having 3 to 20 carbon atoms include: a linear α-olefin such as propylene, 1-butene, 1-pentene, 1-hexene, 1-heptene, 1-octene, 1-nonene, 1-decene, 1-undecene, 1-dodecene, 1-tridecene, 1-tetradecene, 1-heptadecene, 1-hexadecene, 1-heptadecene, 1-octadecene, 1-nanodecene, or 1-eicosene; and a branched α-olefin such as 3-methyl-1-butene, 3-methyl-1-pentene, 4-methyl-1-pentene, 2-ethyl-1-hexene, or 2,2,4-trimethyl-1-pentene. Among these, a combination of two or more kinds may also be used.

From the viewpoint of versatility (cost, mass productivity, or easy availability), the number of carbon atoms in the α-olefin is preferably 3 to 10 and more preferably 3 to 8.

As the ethylene/α-olefin copolymer, an ethylene/propylene copolymer, an ethylene/1-butene copolymer, an ethylene/4-methyl-1-pentene copolymer, an ethylene/1-hexene copolymer, or an ethylene/1-octene copolymer is preferable. In each of all the ethylene/α-olefin copolymers, the content of the constitutional unit derived from ethylene is 50 mol% or higher.

In each of the copolymers, the proportion of the constitutional unit derived from α-olefin is preferably 5 mol% or higher and more preferably 10 mol% or higher with respect to 100 mol% of the total amount of all the constitutional units (monomer units) constituting the copolymer.

As the ethylene/α-olefin copolymer in the adhesive layer (B), one kind may be used alone, or a combination of two or more kinds may be used.

The ethylene/α-olefin copolymer can be manufactured, for example, using a metallocene catalyst and a slurry polymerization method, a solution polymerization method, a block polymerization method, or a vapor phase polymerization method.

The density of the ethylene/α-olefin copolymer measured according to JIS K 7112 is preferably 850 kg/m³ or higher, more preferably 860 kg/m³ or higher, and still more preferably 870 kg/m³ or higher. By adjusting the density of the ethylene/α-olefin copolymer to be the lower limit value or higher, heat resistance can be further improved.

The density of the ethylene/α-olefin copolymer measured according to JIS K 7112 is preferably 920 kg/m³ or lower and more preferably 910 kg/m³ or lower. By adjusting the density of the ethylene/α-olefin copolymer to be the upper limit value or lower, the adhesion performance and transparency of the multilayer sheet can be further improved.

The content of the ethylene based copolymer (B2) in the adhesive layer (B) is preferably 50 mass% or higher and 99 mass% or lower, more preferably 75 mass% or higher and 99 mass% or lower, still preferably 85 mass% or higher and 98 mass% or lower, and even still preferably 90 mass% or higher and 97 mass% or lower with respect to 100 mass% of the total amount of the epoxy group-containing ethylene based copolymer (B1) and the ethylene based copolymer (B2). By adjusting the content of the ethylene based copolymer (B2) to be in the above-described range, a performance balance between transparency, adhesion performance, moisture resistance, insulating performance, flexibility, heat resistance, and workability can be further improved.

It is preferable that at least a part of the epoxy group-containing ethylene based copolymer (B1) and the ethylene based copolymer (B2) in the adhesive layer (B) is graft-modified by a silane coupling agent. As a result, a performance balance between the adhesion performance of the solar cell encapsulant multilayer sheet 10 with a substrate or a solar cell and workability can be further improved.

Here, examples of a method of the graft modification of the silane coupling agent to the epoxy group-containing ethylene based copolymer (B1) and the ethylene based copolymer (B2) include: a method (graft modification method 1) of causing the epoxy group-containing ethylene based copolymer (B1) or the ethylene based copolymer (B2) to react with a silane coupling agent having an amino group or an epoxy group while heating the components (for example, 100°C or higher and 200°C or lower); and a method (graft modification method 2) of performing graft polymerization of a silane coupling agent having a polymerizable group with the epoxy group-containing ethylene based copolymer (B1) or the ethylene based copolymer (B2) using a polymerization initiator.

In the graft modification method 1, the amino group or the epoxy group in the silane coupling agent reacts with the epoxy group or the carboxyl group in the epoxy group-containing ethylene based copolymer (B1) or the ethylene based copolymer (B2) such that the silane coupling agent is grafted to a side chain of the epoxy group-containing ethylene based copolymer (B1) or the ethylene based copolymer (B2).

In the graft modification method 2, for example, the epoxy group-containing ethylene based copolymer (B1) or the ethylene based copolymer (B2), a silane coupling agent having a polymerizable group, and a radical polymerization initiator are kneaded using an extruder, a kneader, a Banbury mixer, or the like while melting them at a temperature which is higher or equal to a melting point of the epoxy group-containing ethylene based copolymer (B1) or the ethylene based copolymer (B2) and is higher or equal to a decomposition temperature of the radical polymerization initiator. As a result, the ethylene/polar monomer copolymer can be manufactured. These reactions can be performed in a solution.

As the polymerization initiator, a typically used polymerization initiator can be used, and an organic peroxide is preferable.

As the organic peroxide, a well-known organic peroxide which can be used as a polymerization initiator can be used, and specific examples thereof include a diacyl peroxide compound, an alkyl peroxy ester compound, a peroxy dicarbonate compound, a peroxy carbonate compound, a peroxy ketal compound, a dialkyl peroxide compound, a hydroperoxide compound, and a ketone peroxide compound.

Among these, a dialkyl peroxide compound is preferable, and 2,5-dimethyl-2,5-di(t-butylperoxy)hexane, 1,3-di(2-t-butylperoxyisopropyl)benzene, di-t-butyl peroxide, or 2,5-dimethyl-2,5-di(t-(butylperoxy)hexyne-3 is more preferable.

The content of the polymerization initiator is typically 0.1 parts by mass or more and 5 parts by mass or less and preferably 0.5 parts by mass or more and 3 parts by mass or less with respect to 100 parts by mass of the total amount of the epoxy group-containing ethylene based copolymer (B1) and the ethylene based copolymer (B2).

Examples of the silane coupling agent having a polymerizable group include vinyltrimethoxysilane, vinyltriethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropylmethyldimethoxysilane, 3-acryloxypropyltrimethoxysilane, 3-acryloxypropylmethyldiethoxysilane, and 3-acryloxypropyltriethoxysilane.

Examples of the silane coupling agent having an amino group include hydrochlorides of N-(2-aminoethyl)-3-aminopropyltrimethoxysilane, N-(2-aminoethyl)-3-aminopropylmethyldimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, and N-(vinylbenzyl)-2-aminoethyl-3-aminopropyltrimethoxysilane.

Examples of the silane coupling agent having an epoxy group include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane.

The content of the silane coupling agent is typically 0.01 mass or more and 5 mass or less, preferably 0.05 parts by mass or more and 3 parts by mass or less, and more preferably 0.1 parts by mass or more and 2 parts by mass or less with respect to 100 parts by mass of the total amount of the epoxy group-containing ethylene based copolymer (B1) and the ethylene based copolymer (B2).

In both the epoxy group-containing ethylene based copolymer (B1) and the ethylene based copolymer (B2), it is preferable that a melt flow rate (JIS K 7210-1999, 190°C, load: 2160 g; hereinafter, abbreviated as "MFR") is in a range of 0.1 g/10 min or higher and 50 g/10 min or lower. Further, MFR is preferably in a range of 0.5 g/10 min or higher and 30 g/10 min or lower and more preferably in a range of 1 g/10 min or higher and 20 g/10 min or lower. By selecting the copolymer in the above-described range, workability on a sheet required as the solar cell encapsulant multilayer sheet 10 can be further improved, and a desired sheet can be obtained. As a result, in a solar cell module is manufactured, an effect of improving adhesion performance and an effect of suppressing unnecessary extrusion can be obtained.

In the adhesive layer (B), the total content of the epoxy group-containing ethylene based copolymer (B1) and the ethylene based copolymer (B2) is preferably 50 mass% or higher, more preferably 65 mass% or higher, still more preferably 80 mass% or higher, and even still more preferably 90 mass% or higher with respect to 100 mass% of the total amount of the adhesive layer (B). In a case where the total content of the epoxy group-containing ethylene based copolymer (B1) and the ethylene based copolymer (B2) is in the above-described range, a performance balance between transparency, adhesion performance, moisture resistance, insulating performance, flexibility, heat resistance, and workability can be further improved.

The adhesive layer (B) may include various additives in a range where the object of the present invention can be achieved. Examples of the additives include a crosslinking agent, a crosslinking aid, a silane coupling agent, an ultraviolet absorber, a light stabilizer, and an antioxidant.

As the additives, those described above regarding the resin layer (A) can be used.

The additives are used for, for example, modifying a resin or improving durability.

The crosslinking aid can be optionally used, and the content of the crosslinking aid is typically 5 parts by mass or less and preferably 0.1 parts by mass or more and 3 parts by mass or less with respect to 100 parts by mass of the total amount of the epoxy group-containing ethylene based copolymer (B1) and the ethylene based copolymer (B2).

The content of the silane coupling agent is typically 5 parts by mass or less and preferably 0.02 parts by mass or more and 3 parts by mass or less with respect to 100 parts by mass of the total amount of the epoxy group-containing ethylene based copolymer (B1) and the ethylene based copolymer (B2). In a case where the content of the silane coupling agent is in the above-described range, the adhesion performance of the multilayer sheet with a protective material, a solar cell element, or the like can be further improved.

The content of each of the antioxidant, the light stabilizer, and the ultraviolet absorber is typically 5 parts by mass or less and preferably 0.1 parts by mass or more and 3 parts by mass or less with respect to 100 parts by mass of the total amount of the epoxy group-containing ethylene based copolymer (B1) and the ethylene based copolymer (B2).

In addition, the adhesive layer (B) may optionally include additives such as a colorant, a light diffusion agent, or a flame retardant other than the above-described additives.

As the additives, those described above regarding the resin layer (A) can be used.

The solar cell encapsulant multilayer sheet 10 according to the embodiment can be manufactured using a well-known method using a multilayer T-die extruder or a multilayer inflation molding machine. For example, a resin composition (A) and a resin composition (B) are supplied from hoppers of a main extruder and a sub-extruder in the multilayer T-die extruder and are extruded from a tip of the T-die extruder in the form of a sheet by multilayer extrusion, wherein the resin composition (A) includes an ethylene/unsaturated carboxylic acid copolymer or an ionomer of the ethylene/unsaturated carboxylic acid copolymer as a major component, and the resin composition (B) includes an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower.

Here, the above-described various additives may be added to the resin composition (A) or the resin composition (B).

### 2. Solar Cell Module

Fig. 2 is a cross-sectional view schematically showing an example of a structure of a solar cell module 1 according to an embodiment of the present invention.

The solar cell module 1 according to the embodiment includes at least: a substrate 2 on which sunlight is incident; solar cell elements 3; a back sheet 4; an encapsulating resin layer 5 that is formed of the solar cell encapsulant multilayer sheet 10 according to the embodiment and encapsulates the solar cell elements 3 between the substrate 2 and the back sheet 4.

The solar cell module 1 according to the embodiment can be manufactured by fixing the solar cell elements 3, which are encapsulated by the solar cell encapsulant multilayer sheet 10 according to the embodiment, to the substrate 2.

As the solar cell module 1, for example, various types of solar cell modules can be used. Examples of the solar cell module 1 include: a solar cell module (substrate 2/solar cell encapsulant multilayer sheet 10/solar cell elements 3/solar cell encapsulant multilayer sheet 10/back sheet 4) having a configuration in which the solar cell elements 3 are interposed between the solar cell encapsulant multilayer sheets 10 from both sides thereof; a solar cell module (substrate 2/solar cell element 3/solar cell encapsulant multilayer sheet 10/back sheet 4) having a configuration in which the solar cell elements 3 that are formed in advance are disposed on a surface of the substrate 2 such as glass; and a solar cell module having a configuration in which the solar cell encapsulant multilayer sheet 10 and the back sheet 4 are formed on a laminate obtained by forming the solar cell elements 3 on an inner peripheral surface of the substrate 2, for example, on a laminate obtained by forming amorphous solar cell elements on a fluorine-based resin sheet by sputtering.

In a case where the solar cell encapsulant multilayer sheet 10 in the solar cell module 1 has a three-layer structure of adhesive layer (B)/resin layer (A)/adhesive layer (B), the layers are laminated such that one of the two adhesive layers (B) as the outer layer are in contact with the solar cell elements 3 and the other adhesive layer (B) as the outer layer is in contact with the substrate 2 or the back sheet 4. In a case where the solar cell encapsulant multilayer sheet 10 in the solar cell module 1 has a two-layer structure of resin layer (A)/adhesive layer (B), it is preferable that the layers are laminated such that the resin layer (A) is in contact with the solar cell elements 3 and the adhesive layer (B) is in contact with the substrate 2 or the back sheet 4.

Examples of the solar cell elements 3 which can be used include various solar cell elements formed of a silicon material such as single crystal silicon, polycrystal silicon, or amorphous silicon, or a group III-V or II-VI compound semiconductor material such as gallium-arsenide, copper-indium-selenide, copper-indium-gallium-selenide, or cadmium-telluride. The solar cell encapsulant multilayer sheet 10 according to the embodiment is particularly useful for encapsulating amorphous silicon solar cell element.

In the solar cell module 1, a plurality of solar cell elements 3 are electrically connected in series through an interconnector 6.

Examples of the substrate 2 constituting the solar cell module 1 include substrates formed of glass, an acrylic resin, polycarbonate, polyester, a fluorine-containing resin, and the like.

The back sheet 4 is a single-layer or multilayer sheet formed of a metal or various thermoplastic resin films, for example, a single-layer or multilayer sheet formed of a metal such as tin, aluminum, or stainless steel, an inorganic material such as glass, polyester, inorganic vapor-deposited polyester, a fluorine-containing resin, or polyolefin. The solar cell encapsulant multilayer sheet 10 according to the embodiment has superior adhesion performance with the substrate 2 or the back sheet 4.

The method of manufacturing the solar cell module 1 is not particularly limited and, for example, is as follows.

First, a plurality of solar cell elements 3 that are electrically connected using the interconnector 6 are interposed between the solar cell encapsulant multilayer sheets 10. Next, the solar cell encapsulant multilayer sheets 10 are interposed between the substrate 2 and the back sheet 4 to prepare a laminate. Next, the laminate is heated and pressed to bond the respective members to each other. As a result, the solar cell module 1 is obtained.

Hereinafter, the embodiments of the present invention have been described with reference to the drawings. However, the embodiments are merely examples of the present invention, and various configurations other than the above-described configurations can also be adopted.

### [Examples]

Hereinafter, the present invention will be described in more detail using Examples. However, the present invention is not limited to these Examples.

The details of components used to prepare a solar cell encapsulant multilayer sheet are as follows.

### <Ethylene/Unsaturated Carboxylic Acid Copolymer or Ionomer thereof>

EMAc1 (A): an ionomer of an ethylene/methacrylic acid copolymer (ethylene content: 85 mass%, methacrylic acid content: 15 mass%, 23% zinc neutralized)
EMAc2 (A): an ionomer of an ethylene/methacrylic acid copolymer (ethylene content: 85 mass%, methacrylic acid content: 15 mass%, 54% magnesium neutralized)
EMAc3 (A): an ionomer of an ethylene/methacrylic acid/butyl acrylate copolymer (ethylene content: 80%, methacrylic acid content: 10%, butyl acrylate: 10%, 70% zinc neutralized)

### <Stabilizer Masterbatch>

Predetermined amounts of EMAc1 (A), antioxidant: pentaerythritol tetrakis[3-(3,5-di-tert-butyl-4-hydroxyphenyl)propionate] (manufactured by BASF SE, Irganox 1010), ultraviolet absorber: 2-(2H-benzotriazol-2-yl)-4,6-di-tert-pentylphenol, and light stabilizer: bis(2,2,6,6-tetramethyl-4-piperidyl)sebacate were melted and kneaded in advance using a twin screw extruder to obtain a stabilizer masterbatch.

### <EGMAVA-Modified Composition>

49 parts of an ethylene/glycidyl methacrylate/vinyl acetate copolymer (EGMAVA, manufactured by Sumitomo Chemical Co., Ltd., BONDFAST 7B, ethylene content: 83 mass%, glycidyl methacrylate content: 12 mass%, vinyl acetate content: 5 mass%, MFR (190°C, load: 2160 g) : 7 g/10 min), 49 parts by mass of an ethylene/vinyl acetate copolymer (vinyl acetate content: 19 mass%), 1.5 parts by mass of γ-methacryloxypropyltrimethoxysilane (manufactured by Shin-Etsu Chemical Co., Ltd., trade name "KBM 503"), and 0.5 parts of 2,5-dimethyl-2,5-di(t-butylperoxy)hexane (manufactured by ARKEMA Yoshitomi, Ltd., trade name: "LUPEROX 101") were mixed with each other in advance and were graft-polymerized using a single screw extruder at a melting temperature of 220°C to obtain an EGMAVA-modified composition 1. Here, in the EGMAVA-modified composition 1, EGMAVA (also referred to as "EGMAVA modified product 1") to which γ-methacryloxypropyltrimethoxysilane was grafted corresponds to the epoxy group-containing ethylene based copolymer (B1) according to the embodiment, and the ethylene/vinyl acetate copolymer to which γ-methacryloxypropyltrimethoxysilane was grafted corresponds to the ethylene based copolymer (B2) according to the embodiment.

### <Ethylene based Copolymer (B2)>

EVA 1: ethylene/vinyl acetate copolymer (ethylene content: 90 mass%, vinyl acetate content: 10 mass%)
LDPE 1: low-density polyethylene (manufactured by Du Pont-Mitsui Polychemicals Co., Ltd., MIRASON 68P, density: 918 kg/m³)
LDPE 2: low-density polyethylene (manufactured by Du Pont-Mitsui Polychemicals Co., Ltd., MIRASON 401, density: 920 kg/m³)
EMA 1: ethylene/methyl acrylate copolymer (ethylene content: 80 mass%, methyl acrylate content: 20 mass%, MFR: 8 g/10 min)
EEA 1: ethylene/ethyl acrylate copolymer (ethylene content: 85 mass%, methyl acrylate content: 15 mass%, MFR: 6 g/10 min)
EBA 1: ethylene/butyl acrylate copolymer (ethylene content: 83 mass%, methyl butyl acrylate content: 17 mass%, MFR: 7 g/10 min)
EC1: ethylene/α-olefin copolymer (manufactured by Mitsui Chemicals, Inc., TAFMER DF840, MFR: 3.6 g/10 min, density: 885 kg/m³)
EC2: ethylene/α-olefin copolymer (manufactured by Mitsui Chemicals, Inc., TAFMER DF940, MFR: 3.6 g/10 min, density: 893 kg/m³)
EC3: ethylene/α-olefin copolymer (manufactured by Prime Polymer Co., Ltd., EVOLUE SP0540, MFR: 3.8 g/10 min, density: 903 kg/m³)
EC4: ethylene/α-olefin copolymer (manufactured by Prime Polymer Co., Ltd., EVOLUE SP2540, MFR: 3.8 g/10 min, density: 924 kg/m³)

### [Example 1]

10 parts by mass of the EGMAVA-modified composition 1 and 90 parts by mass of the ethylene based copolymer EVA1 (B2) were dry-blended to prepare a resin composition (B) (composition (B-1), and the resin composition (B) was used to form an outer layer 1 and an outer layer 2. 90 parts by mass of EMAc1 (A) and 10 parts by mass of the stabilizer masterbatch were dry-blended to prepare a resin compositions, and the resin composition was used to form an intermediate layer. Using the resin compositions and a two kind-three layer T-die molding machine, a multilayer sheet having a total thickness of 400 µm (0.4 mm) was prepared at a resin temperature of 180°C such that a thickness ratio outer layer 1/intermediate layer/outer layer 2 was 67 µm/266 µm/ 67 µm.

### <Evaluation>

### (1) Evaluation of Adhesion Performance

Using a vacuum heat bonding machine (double chamber bonding machine manufactured by NPC, LM-50X50S), glass having a thickness of 3.2 mm, the obtained multilayer sheet, and non-corona-treated PET were laminated in this order and bonded under conditions of a heating temperature of 160°C and a heating time of 8 minutes. Next, the bonded laminate was left to stand in air and was allowed to slowly cool. A slit having a width of 15 mm was formed in the sheet portion of the completed laminate to prepare a test piece, and the test piece was mounted on a tensile tester. The PET of the multilayer sheet was pulled away at a tension rate of 100 mm/min, and the maximum stress was obtained as an initial adhesion strength (N/15 mm).

In addition, the laminate was stored under conditions of 85°C and a humidity of 90% RH for 1000 hours to obtain an adhesion strength after 500 hours and an adhesion strength for 1000 hours, respectively. The obtained adhesion strength was obtained as a PET adhesion strength of the laminate. The obtained results are shown in Table 2.

### (2) Evaluation of Transparency

Glass having a thickness of 3.2 mm, the obtained multilayer sheet, and glass having a thickness of 3.2 mm were laminated in this order, and a laminate was prepared using the method described above regarding "(1) Evaluation of Adhesion Performance". Using a haze meter (manufactured by Suga Test Instruments Co., Ltd.), a total light transmittance (unit: %) and a haze value (unit: %) of the laminate were measured according to JIS K 7136. The obtained results are shown in Table 2.

### (3) Evaluation of Moisture Permeability

Using a cup method (according to JIS Z 0208, measurement atmosphere: 40°C×90% RH), the water-vapor permeability (g/m²·24h) of the multilayer sheet was measured. The obtained results are shown in Table 2.

### (4) Volume Specific Resistivity

A volume specific resistivity of the multilayer sheet was measured according to JIS C 2139 (2008). The obtained results are shown in Table 2.

### [Examples 2 to 7, Comparative Examples 1 to 3]

Multilayer sheets were prepared using the same method as in Example 1, except that compositions (B-2) to (B-10) shown in Table 1 were used as the adhesive layer instead of the composition (B-1) of the outer layers 1 and 2, respectively. Using the multilayer sheets, the same evaluations as in Example 1 were performed. The obtained results are shown in Tables 2 and 3.

### [Examples 8 and 9]

Stabilizer masterbatches and intermediate layers were prepared, except that EMAc2 (A) and EMAc3 (A3) were used instead of EMAc1 (A), respectively. Next, multilayer sheets were prepared using the same method as in Example 5, except that the obtained intermediate layers were used, respectively. Using the multilayer sheets, the same evaluations as in Example 1 were performed. The obtained results are shown in Table 3.

### [Comparative Example 4]

Using a single screw extruder, EVA1 was extruded into the form of a sheet at a resin temperature of 100°C to prepare a resin sheet having a thickness of 400 µm (0.4 mm). Using the resin sheet, the same evaluations as in Example 1 were performed. The obtained results are shown in Table 3.

### [Comparative Example 5]

A single-layer sheet was prepared using the same method as in Example 1, except that the outer layers 1 and 2 were not provided. Using the single-layer sheet, the same evaluations as in Example 1 were performed. The obtained results are shown in Table 3.

**Table 1**

| | Composition | B-1 | B-2 | B-3 | B-4 | B-5 | B-6 | B-7 | B-8 | B-9 | B-10 |
|---|---|---|---|---|---|---|---|---|---|---|---|
| EGMAVA-Modified Composition 1 | Part(s) by Mass | 10 | 10 | 10 | 10 | 10 | 10 | 10 | 10 | 10 | 10 |
| EVA1 | Part(s) by Mass | 90 | - | - | - | - | - | - | - | - | - |
| LDPE1 | Part(s) by Mass | - | 90 | - | - | - | - | - | - | - | - |
| LDPE2 | Part(s) by Mass | - | - | 90 | - | - | - | - | - | - | - |
| EMA1 | Part(s) by Mass | - | - | - | 90 | - | - | - | - | - | - |
| EEA1 | Part(s) by Mass | - | - | - | - | 90 | - | - | - | - | - |
| EBA1 | Part(s) by Mass | - | - | - | - | - | 90 | - | - | - | - |
| EC1 | Part(s) by Mass | - | - | - | - | - | - | 90 | - | - | - |
| EC2 | Part(s) by Mass | - | - | - | - | - | - | - | 90 | - | - |
| EC3 | Part(s) by Mass | - | - | - | - | - | - | - | - | 90 | - |
| EC4 | Part(s) by Mass | - | - | - | - | - | - | - | - | - | 90 |

**Table 2**

| | | Example 1 | Example 2 | Example 3 | Example 4 | Example 5 | Example 6 | Example 7 |
|---|---|---|---|---|---|---|---|---|
| Layer Configuration | Outer Layer 1 | B-1 | B-4 | B-5 | B-6 | B-7 | B-8 | B-9 |
| | Intermediate Laver | EMAc1 | EMAc1 | EMAc1 | EMAc1 | EMAc1 | EMAc1 | EMAc1 |
| | Outer Layer 2 | B-1 | B-4 | B-5 | B-6 | B-7 | B-8 | B-9 |

| Adhesion Performance | | | | | | | | |
|---|---|---|---|---|---|---|---|---|
| Initial | N/15 mm | 22.7 | 28.2 | 21.0 | 30.6 | 21.1 | 25.3 | 12.5 |
| After 500 h (85°C, 90% RH) | N/15 mm | 19.9 | 27.8 | 24.3 | 28.5 | 33.1 | 28.3 | 20.5 |
| After 1000 h (85°C, 90% RH) | N/15 mm | 18.9 | 43.0 | 23.1 | 23.5 | 27.3 | 27.5 | 18.4 |

| Transparency | | | | | | | | |
|---|---|---|---|---|---|---|---|---|
| Total Light Transmittance | % | 88.8 | 90.2 | 89.7 | 88.3 | 89.9 | 90.0 | 88.4 |
| Haze | % | 18.6 | 15.1 | 23.0 | 26.4 | 8.1 | 4.5 | 29.2 |

| Moisture Permeability | | | | | | | | |
|---|---|---|---|---|---|---|---|---|
| Water-Vapor Permeability | g/m²·day (40°C, 90% RH) | 13.3 | 2.1 | 2.2 | 2.2 | 2.1 | 1.9 | 1 . 7 |

| Insulating Performance | | | | | | | | |
|---|---|---|---|---|---|---|---|---|
| Volume Specific Resistivity | Ω·cm (23°C, 50% RH) | 1.79×10¹⁷ | 2.58×10¹⁶ | 3.48×10¹⁶ | 9.37×10¹⁶ | 1.16×10¹⁵ | 1.65×10¹⁵ | 5.64×10¹⁶ |

**Table 3**

| | | Example 8 | Example 9 | Comparative Example 1 | Comparative Example 2 | Comparative Example 3 | Comparative Example 4 | Comparative Example 5 |
|---|---|---|---|---|---|---|---|---|
| Layer Configuration | Outer Layer 1 | B-7 | B-7 | B-2 | B-3 | B-10 | EVA1 | EMAc1 |
| | Intermediate Laver | EMAc2 | EMAc3 | EMAc1 | EMAc1 | EMAc1 | | |
| | Outer Layer 2 | B-7 | B-7 | B-2 | B-3 | B-10 | | |

| Adhesion Performance | | | | | | | | |
|---|---|---|---|---|---|---|---|---|
| Initial | N/15 mm | 15.8 | 20.5 | Not Bonded | Not Bonded | Not Bonded | 25.0 | Not Bonded |
| After 500 h (85°C, 90% RH) | N/15 mm | 19.9 | 19 | | | | - | |
| After 1000 h (85°C, 90% RH) | N/15 mm | 19.1 | 17.1 | | | | 4.0 | |

| Transparency | | | | | | | | |
|---|---|---|---|---|---|---|---|---|
| Total Light Transmittance | % | 90.7 | 88.8 | 88.3 | 86.4 | 87.9 | 89.5 | 90.9 |
| Haze | % | 18.6 | 18.6 | 60.4 | 46.0 | 54.2 | 0.52 | 2.3 |

| Moisture Permeability | | | | | | | | |
|---|---|---|---|---|---|---|---|---|
| Water-Vapor Permeability | g/m²·day (40°C, 90% RH) | 2.5 | 5.5 | | | | 27.4 | 1.7 |

| Insulating Performance | | | | | | | | |
|---|---|---|---|---|---|---|---|---|
| Volume Specific Resistivity | Ω·cm (23°C, 50% RH) | 2.38×10¹⁶ | 7.22×10¹⁶ | | | | 1.70×10¹⁴ | 3.80×10¹⁸ |

In the multilayer sheets according to Examples 1 to 9, a performance balance between transparency, adhesion performance, moisture resistance, and insulating performance was good. On the other hand, in the sheets according to Comparative Examples 1 to 5, a performance balance between transparency, adhesion performance, moisture resistance, and insulating performance was poor.

The present application claims priority based on Japanese Patent Application No. 2015-191210, filed on September 29, 2015, the entire content of which is incorporated herein by reference.

## Claims

1. A solar cell encapsulant multilayer sheet comprising:
a resin layer (A) that includes an ethylene/unsaturated carboxylic acid copolymer or an ionomer of the ethylene/unsaturated carboxylic acid copolymer as a major component; and
an adhesive layer (B), wherein the adhesive layer (B) includes an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower, and
wherein the adhesive layer (B) is provided on both surfaces of the resin layer (A).

2. The solar cell encapsulant multilayer sheet according to claim 1,
wherein a total thickness is 50 µm or more and 2000 µm or less.

3. The solar cell encapsulant multilayer sheet according to claim 1 or 2,
wherein the epoxy group-containing ethylene based copolymer (B1) includes at least one selected from the group consisting of an ethylene/glycidyl (meth)acrylate copolymer, an ethylene/glycidyl (meth)acrylate/vinyl acetate copolymer, and an ethylene/glycidyl (meth)acrylate/(meth)acrylic acid ester copolymer.

4. The solar cell encapsulant multilayer sheet according to any one of claims 1 to 3,
wherein the ethylene/polar monomer copolymer includes at least one selected from the group consisting of an ethylene/vinyl ester copolymer, an ethylene/unsaturated carboxylic acid ester copolymer, and an ethylene/unsaturated carboxylic acid copolymer.

5. The solar cell encapsulant multilayer sheet according to any one of claims 1 to 4,
wherein at least a part of the epoxy group-containing ethylene based copolymer (B1) and the ethylene based copolymer (B2) in the adhesive layer (B) is graft-modified by a silane coupling agent.

6. The solar cell encapsulant multilayer sheet according to any one of claims 1 to 5,
wherein a content of the ethylene based copolymer (B2) in the adhesive layer (B) is 50 mass% or higher and 99 mass% or lower with respect to 100 mass% of a total amount of the epoxy group-containing ethylene based copolymer (B1) and the ethylene based copolymer (B2).

7. The solar cell encapsulant multilayer sheet according to any one of claims 1 to 6,
wherein the resin layer (A) includes an ionomer of the ethylene/unsaturated carboxylic acid copolymer as a major component.

8. The solar cell encapsulant multilayer sheet according to any one of claims 1 to 7,
wherein the solar cell encapsulant multilayer sheet is used for adhesion with an electrically insulating resin film layer having at least one surface that is not corona-treated.

9. A method of manufacturing the solar cell encapsulant multilayer sheet according to any one of claims 1 to 8, the method comprising:
a step of extruding a resin composition (A) and a resin composition (B) by multilayer extrusion, the resin composition (A) including an ethylene/unsaturated carboxylic acid copolymer or an ionomer of the ethylene/unsaturated carboxylic acid copolymer as a major component, and the resin composition (B) including an epoxy group-containing ethylene based copolymer (B1) and at least one ethylene based copolymer (B2) (excluding the epoxy group-containing ethylene based copolymer (B1)) selected from the group consisting of an ethylene/polar monomer copolymer and an ethylene/α-olefin copolymer having a density of 920 kg/m³ or lower.

10. A solar cell module comprising:
a substrate on which sunlight is incident;
a solar cell element;
a back sheet; and
an encapsulating resin layer that is formed of the solar cell encapsulant multilayer sheet according to any one of claims 1 to 8 and encapsulates the solar cell element between the substrate and the back sheet.

## Patentansprüche

1. Mehrschichtige Solarzellenverkapselungsfolie, umfassend:
eine Harzschicht (A), die ein Ethylen/ungesättigte Carbonsäure-Copolymer oder ein Ionomer des Ethylen/ungesättigte Carbonsäure-Copolymers als Hauptkomponente umfasst; und
eine Haftschicht (B), wobei die Haftschicht (B) ein Epoxygruppen enthaltendes Copolymer auf Ethylenbasis (B1) und mindestens ein Copolymer auf Ethylenbasis (B2) (mit Ausnahme des Epoxygruppen enthaltenden Copolymers auf Ethylenbasis (B1)), ausgewählt aus der Gruppe bestehend aus einem Ethylen/polares Monomer-Copolymer und einem Ethylen/α-Olefin-Copolymer mit einer Dichte von 920 kg/m³ oder kleiner, umfasst, und
wobei die Haftschicht (B) auf beiden Oberflächen der Harzschicht (A) vorgesehen ist.

2. Mehrschichtige Solarzellenverkapselungsfolie nach Anspruch 1,
wobei eine Gesamtdicke 50 µm oder mehr und 2000 µm oder weniger beträgt.

3. Mehrschichtige Solarzellenverkapselungsfolie nach Anspruch 1 oder 2,
wobei das Epoxygruppen enthaltende Copolymer auf Ethylenbasis (B1) mindestens eines, ausgewählt aus der Gruppe bestehend aus einem Ethylen/Glycidyl(meth)acrylat-Copolymer, einem Ethylen/Glycidyl(meth)acrylat/Vinylacetat-Copolymer und einem Ethylen/Glycidyl(meth)acrylat/(Meth)acrylsäureester-Copolymer, umfasst.

4. Mehrschichtige Solarzellenverkapselungsfolie nach einem der Ansprüche 1 bis 3,
wobei das Ethylen/polares Monomer-Copolymer mindestens eines, ausgewählt aus der Gruppe bestehend aus einem Ethylen/Vinylester-Copolymer, einem Ethylen/ungesättigter Carbonsäureester-Copolymer und einem Ethylen/ungesättigte Carbonsäure-Copolymer, umfasst.

5. Mehrschichtige Solarzellenverkapselungsfolie nach einem der Ansprüche 1 bis 4,
wobei zumindest ein Teil des Epoxygruppen enthaltenden Copolymers auf Ethylenbasis (B1) und des Copolymers auf Ethylenbasis (B2) in der Haftschicht (B) mit einem Silan-Haftvermittler pfropfmodifiziert ist.

6. Mehrschichtige Solarzellenverkapselungsfolie nach einem der Ansprüche 1 bis 5,
wobei ein Gehalt an dem Copolymer auf Ethylenbasis (B2) in der Haftschicht (B) 50 Masse-% oder höher und 99 Masse-% oder niedriger in Bezug auf 100 Masse-% einer Gesamtmenge des Epoxygruppen enthaltenden Copolymers auf Ethylenbasis (B1) und des Copolymers auf Ethylenbasis (B2) ist.

7. Mehrschichtige Solarzellenverkapselungsfolie nach einem der Ansprüche 1 bis 6,
wobei die Harzschicht (A) ein Ionomer des Ethylen/ungesättigte Carbonsäure-Copolymers als Hauptkomponente umfasst.

8. Mehrschichtige Solarzellenverkapselungsfolie nach einem der Ansprüche 1 bis 7,
wobei die mehrschichtige Solarzellenverkapselungsfolie zur Adhäsion mit einer elektrisch isolierenden Harzfilmschicht mit mindestens einer Oberfläche, die nicht koronabehandelt ist, verwendet wird.

9. Verfahren zur Herstellung der mehrschichtigen Solarzellenverkapselungsfolie nach einem der Ansprüche 1 bis 8, wobei das Verfahren umfasst:
einen Schritt des Extrudierens einer Harzzusammensetzung (A) und einer Harzzusammensetzung (B) mittels Mehrschichtextrusion, wobei die Harzzusammensetzung (A) ein Ethylen/ungesättigte Carbonsäure-Copolymer oder ein Ionomer des Ethylen/ungesättigte Carbonsäure-Copolymers als Hauptkomponente umfasst, und wobei die Harzzusammensetzung (B) ein Epoxygruppen enthaltendes Copolymer auf Ethylenbasis (B1) und mindestens ein Copolymer auf Ethylenbasis (B2) (mit Ausnahme des Epoxygruppen enthaltenden Copolymers auf Ethylenbasis (B1)), ausgewählt aus der Gruppe bestehend aus einem Ethylen/polares Monomer-Copolymer und einem Ethylen/α-Olefin-Copolymer mit einer Dichte von 920 kg/m³ oder kleiner, umfasst.

10. Solarzellenmodul, umfassend:
ein Substrat, auf das Sonnenlicht auftrifft;
ein Solarzellenelement;
eine Rückseitenfolie; und
eine verkapselnde Harzschicht, die aus der mehrschichtigen Solarzellenverkapselungsfolie nach einem der Ansprüche 1 bis 8 gebildet ist und das Solarzellenelement zwischen dem Substrat und der Rückseitenfolie verkapselt.

## Revendications

1. Feuille multicouches d'encapsulation d'une cellule solaire comprenant :
une couche d'une résine (A) qui inclut un copolymère éthylène/acide carboxylique insaturé ou un ionomère du copolymère éthylène/acide carboxylique insaturé comme composant principal ; et
une couche d'un adhésif (B), où la couche d'adhésif (B) inclut un copolymère à base d'éthylène contenant un groupement époxy (B1) et au moins un copolymère à base d'éthylène (B2) [autre que le copolymère à base d'éthylène contenant un groupement époxy (B1)] sélectionné dans le groupe consistant en un copolymère éthylène/monomère polaire et un copolymère éthylène/α-oléfine ayant une masse volumique inférieure ou égale à 920 kg/m³ et
où la couche d'adhésif (B) est fournie sur les deux surfaces de la couche de résine (A).

2. Feuille multicouches d'encapsulation d'une cellule solaire selon la revendication 1,
où une épaisseur totale est égale ou supérieure à 50 µm et inférieure ou égale à 2 000 µm.

3. Feuille multicouches d'encapsulation d'une cellule solaire selon la revendication 1 ou 2,
où le copolymère à base d'éthylène contenant un groupement époxy (B1) inclut un au moins sélectionné dans le groupe consistant en un copolymère éthylène/(méth)acrylate de glycidyle, un copolymère éthylène/(méth)acrylate de glycidyle/acétate de vinyle et un copolymère éthylène/(méth)acrylate de glycidyle/ester d'un acide (méth)acrylatique.

4. Feuille multicouches d'encapsulation d'une cellule solaire selon l'une quelconque des revendications 1 à 3,
où le copolymère éthylène/monomère polaire inclut un au moins sélectionné dans le groupe consistant en un copolymère éthylène/ester vinylique, un copolymère éthylène/ester d'un acide carboxylique insaturé et un copolymère éthylène/acide carboxylique insaturé.

5. Feuille multicouches d'encapsulation d'une cellule solaire selon l'une quelconque des revendications 1 à 4,
où une partie au moins du copolymère à base d'éthylène contenant un groupement époxy (B1) et du copolymère à base d'éthylène (B2) dans la couche d'adhésif (B) est modifiée par greffage d'un agent de couplage d'un silane.

6. Feuille multicouches d'encapsulation d'une cellule solaire selon l'une quelconque des revendications 1 à 5,
ou une teneur en le copolymère à base d'éthylène (B2) dans la couche d'adhésif (B) représente 50 % en masse ou plus et 99 % en masse ou moins pour 100 % en masse d'une quantité totale du copolymère à base d'éthylène contenant un groupement époxy (B1) et du copolymère à base d'éthylène (B2).

7. Feuille multicouches d'encapsulation d'une cellule solaire selon l'une quelconque des revendications 1 à 6,
où la couche de résine (A) inclut un ionomère du copolymère éthylène/acide carboxylique insaturé comme composant principal.

8. Feuille multicouches d'encapsulation d'une cellule solaire selon l'une quelconque des revendications 1 à 7,
où la feuille multicouches d'encapsulation d'une cellule solaire est utilisée pour l'adhésion à une couche d'un film d'une résine électriquement isolante ayant au moins une surface qui n'a pas subi un traitement corona.

9. Procédé de fabrication d'une feuille multicouches d'encapsulation d'une cellule solaire selon l'une quelconque des revendications 1 à 8, le procédé comprenant :
une étape d'extrusion d'une composition résinique (A) et d'une composition résinique (B) par extrusion multicouches, la composition résinique (A) incluant un copolymère éthylène/acide carboxylique insaturé ou un ionomère du copolymère éthylène/acide carboxylique insaturé comme composant principal et la composition résinique (B) incluant un copolymère à base d'éthylène contenant un groupement époxy (B1) et au moins un copolymère à base d'éthylène (B2) [autre que le copolymère à base d'éthylène contenant un groupement époxy (B1)] sélectionné dans le groupe consistant en un copolymère éthylène/monomère polaire et un copolymère éthylène/α-oléfine ayant une masse volumique inférieure ou égale à 920 kg/m³.

10. Module de cellule solaire comprenant :
un substrat sur lequel la lumière du soleil est incidente ;
un élément de cellule solaire ;
une feuille arrière ; et
une couche d'une résine d'encapsulation qui est constituée de la feuille multicouches d'encapsulation d'une cellule solaire selon l'une quelconque des revendications 1 à 8 et qui encapsule l'élément de cellule solaire entre le substrat et la feuille arrière.
